# EUROPEAN PATENT APPLICATION

(11) **EP 4 502 040 A1**
(43) Date of publication of application: **05.02.2025**
(21) Application number: 23780610.4
(22) Date of filing: 28.03.2023
(51) Int. Cl.: C08L 23/00, B32B 15/08, B32B 27/18, B32B 27/32, C08F 299/00, C08K 5/13, C08K 5/372, C08K 5/524, C08L 25/00, H05K 1/03

(54) **COMPOSITION**

(30) Priority: 28.03.2022 JP 2022052523
(71) Applicant: Denka Company Limited, Tokyo 103-8338 (JP)
(72) Inventor: KANTO,Ryosuke, Tokyo 103-8338 (JP); ONUKI,Suguru, Tokyo 103-8338 (JP); ISHIGAKI,Yuhei, Tokyo 103-8338 (JP); YOSHIDA,Jun, Tokyo 103-8338 (JP)
(74) Representative: Müller-Boré & Partner Patentanwälte PartG mbB
(86) International application number: PCT/JP2023/012674
(87) International publication number: WO 2023/190601

(57) **Abstract**

To achieve both excellent dielectric properties and long-term durability. A composition comprising (A) a curable hydrocarbon-based resin, (B) a phenolic antioxidant, (C) a thioether-based antioxidant, and (D) a phosphorus-based antioxidant, wherein a total amount of substance of the components (B), (C), and (D) is within a range of 2 to 10 mmol, based on 100 g of the mass of the component (A) in the composition.

## Description

### FIELD OF THE INVENTION

The present invention relates to a composition.

### BACKGROUND ART

Due to the shift of communication frequency to gigahertz bands and frequency bands higher than those, needs for insulating materials having low dielectric properties have increased. This is because a transmission loss is known to be approximately equal to the sum of a dielectric loss which is proportional to a dielectric tangent and a conductor loss. With existing materials such as epoxy resins, it is difficult to lower the dielectric constant and dielectric loss, and therefore development of a new material has been pursued. For example, Patent Literature 1 discloses an electrical insulating material made of a graft or block copolymer composed of olefin-based and styrenebased polymer segments.

These materials, also called electrical insulating materials or LDMs (Low Dielectric Macromonomers), are often continuously exposed to extremely high temperatures and are required for their durability for a long period of time without being easily replaceable due to their use in electronic machinery. In spite thereof, there is a trend toward even lower dielectric constants and dielectric losses than before. In the field of polymer materials, various additives that claim to prevent material aging of the materials are generally available on the market, but they affect the dielectric constant and dielectric loss, making it less easy for LDM products to adopt the additives.

For example, Patent Literature 2 discloses a solar cell module that uses a so-called cross copolymer as an encapsulant, and various additives are also exemplified. However, the level of dielectric constant and dielectric loss required for current LDM products has not been taken into consideration at that time.

### PIOR ART

### Patent Literature

[Patent Literature 1] Japanese Patent Laid-Open No. H11-060645
[Patent Literature 2] Japanese Patent Laid-Open No. 2014-127544

### SUMMARY OF THE INVENTION

### TECHNICAL PROBLEM

A novel object is to achieve long-term durability (in particular durability under high temperature exposure), while also obtaining a level of dielectric constant and dielectric loss required for current LDM products, which have not been possible with conventional technology.

### SOLUTION TO PROBLEM

In order to solve the above-described problems, the following aspects may be provided in the present invention.

### Aspect 1.

A composition, comprising:
(A) a curable hydrocarbon-based resin;
(B) a phenolic antioxidant;
(C) a thioether-based antioxidant; and
(D) a phosphorus-based antioxidant, and
wherein a total amount of substance of the components (B), (C), and (D) is within a range of 2 to 10 mmol, based on 100 g of a mass of the component (A) in the composition.

### Aspect 2.

The composition according to aspect 1, wherein an amount of substance per phenol moiety of the component (B) is in a range of 0.5 to 4 mmol, an amount of substance per thioether moiety of the component (C) is in a range of 0.5 to 4 mmol, and an amount of substance per phosphite moiety of the component (D) is in a range of 0.5 to 4 mmol, based on 100 g of a mass of the component (A) in the composition.

### Aspect 3.

The composition according to aspect 1 or 2, wherein the component (A) comprises an olefin-aromatic vinyl compound-aromatic polyene copolymer.

### Aspect 4.

The composition according to aspect 3, wherein the component (A) satisfies all of the following conditions (1) to (4):
(1) a number average molecular weight of the copolymer is 500 or more and 100,000 or less;
(2) an aromatic vinyl compound monomer is an aromatic vinyl compound having 8 or more and 20 or less carbon atoms, and a content of the aromatic vinyl compound monomer unit is 0 mass% or more and 70 mass% or less;
(3) an aromatic polyene monomer unit is one or more selected from polyenes having 5 or more and 20 or less carbon atoms and having a plurality of vinyl groups and/or vinylene groups in the molecule, and a content of the vinyl group and/or vinylene group derived from the aromatic polyene monomer unit is 1.5 pieces or more and less than 20 pieces per number average molecular weight; and
(4) an olefin monomer unit is one or more selected from olefins having 2 or more and 20 or less carbon atoms, and a total of units of the olefin monomer, the aromatic vinyl compound monomer, and the aromatic polyene monomer is 100 mass%.

### Aspect 5.

The composition according to any one of aspects 1 to 4, wherein, given that the value of a dielectric tangent of a cured product of the composition in a measurement frequency range of 40 GHz as determined by a resonator method is defined as X1, and
given that the value of a dielectric tangent of a cured product of the composition after being heated at 175°C for 24 hours, in a measurement frequency range of 40 GHz as determined by the resonator method is defined as X2,
the value of (X1/X2) is 2 or less.

### Aspect 6.

The composition according to any one of aspects 1 to 5, wherein the component (B) has two or more aromatic rings in one molecule.

### Aspect 7.

The composition according to any one of aspects 1 to 6, wherein the component (C) has an acyclic structure.

### Aspect 8.

The composition according to any one of aspects 1 to 7, wherein the component (D) has an aromatic ring in its molecule.

### Aspect 9.

A cured product of the composition according to any one of aspects 1 to 8.

### Aspect 10.

A laminate, comprising:
a layer comprising the composition according to any one of aspects 1 to 8; and
a metal foil.

### Aspect 11.

A cured product of the laminate according to aspect 10.

### Aspect 12.

A single-layer CCL, multilayer CCL, single-layer FCCL, or multilayer FCCL substrate comprising the cured product according to claim 11.

### ADVANTAGEOUS EFFECT OF INVENTION

The composition according to the present invention provides an effect of exhibiting long-term durability even in harsh environments while having excellent dielectric properties.

### DETAILED DESCRIPTION OF THE INVENTION

In the specification, the term "sheet" also includes a concept of a film. Further, the term "film" described in the specification also includes the concept of a sheet. The term "composition" described in the present specification refers to a concept including a varnish. In other words, a composition particularly in liquid form is described as a varnish. The order of each step included in the method disclosed in the present specification may be freely changed chronologically as long as the effect can be exhibited. The numerical ranges in the present specification include the lower limits and the upper limits unless otherwise specified.

The composition according to the present invention is characterized by containing (A) a curable hydrocarbon-based resin (hereinafter may be simply referred to as "resin") and, relative to the resin, predetermined amounts of (B) a phenolic antioxidant and (C) a thioether-based antioxidant.

The component (A) may be any curable hydrocarbon-based resin, which has a functional group that can be cured (thermally) in the presence of heat or a radical polymerization initiator. The presence of the component (A) allows a cured product of the present composition to satisfy heat resistance required for an electrical insulating material. The functional group is not limited as long as it may be cured by heat or radicals, but is preferably one or more of the group consisting of a vinyl group, a vinylene group, and an allyl group. For example, such a component (A) may be a polyfunctional vinyl aromatic copolymer obtained by the cationic polymerization reaction described in International Publication No. WO 2018/181842 and International Publication No. 2017/115813, or it may be a polyphenylene-based ether resin having a functional group, such as SA-9000 manufactured by SABIC or OPE-2St manufactured by MITSUBISHI GAS CHEMICAL COMPANY, INC., or a polyether (ketone) having a functional group, or a polymer or copolymer having a 1,2-polybutadiene structure, such as the product name "Ricon" manufactured by Cray Valley S. A. Further, an example of the component (A) includes an olefin-aromatic vinyl compound-aromatic polyene copolymer obtained by a single-site coordination polymerization reaction. These may be used singly or may be a composition composed of a plurality thereof. Most preferably, the component (A) may contain a polyfunctional vinyl aromatic copolymer or an olefin-aromatic vinyl compound-aromatic polyene copolymer, the constituents of which are substantially carbon atoms and hydrogen atoms.

The component (A) may most preferably contain an olefin-aromatic vinyl compound-aromatic polyene copolymer (hereinafter may be simply referred to as "copolymer"). The olefin-aromatic vinyl compound-aromatic polyene copolymer is a compound obtained by copolymerizing each of monomers of an olefin, an aromatic vinyl compound, and aromatic polyene. The component (A) may be a monomer, an oligomer, or a mixture thereof. The component (A) preferably satisfies all of the following conditions (1) to (4):
(1) a number average molecular weight of the copolymer is 500 or more and 100,000 or less.
(2) an aromatic vinyl compound monomer is an aromatic vinyl compound having 8 or more and 20 or less carbon atoms, and a content of the aromatic vinyl compound monomer unit is 0 mass% or more and 70 mass% or less.
(3) an aromatic polyene monomer unit is one or more selected from polyenes having 5 or more and 20 or less carbon atoms and having a plurality of vinyl groups and/or vinylene groups in the molecule, and a content of the vinyl group and/or vinylene group derived from the aromatic polyene monomer unit is 1.5 pieces or more and less than 20 pieces per number average molecular weight.
(4) an olefin monomer unit is one or more selected from olefins having 2 or more and 20 or less carbon atoms, and a total of units of the olefin monomer, the aromatic vinyl compound monomer, and the aromatic polyene monomer is 100 mass%.

The olefin monomer may be one or more selected from α-olefins having 2 or more and 20 or less carbon atoms and cyclic olefins having 5 or more and 20 or less carbon atoms, which is a compound composed of carbon and hydrogen, substantially containing no oxygen, nitrogen, or halogen. Examples of the α-olefin having 2 or more and 20 or less carbon atoms include ethylene, propylene, 1-butene, 1-hexene, 1-octene, 1-decene, 1-dodecene, 4-methyl-1-pentene, 3,5,5-trimethyl-1-hexene, and the like. Examples of the cyclic olefin having 5 or more and 20 or less may include carbon atoms, norbornene and cyclopentene. The olefin that may be preferably used is a combination of ethylene with an α-olefin other than ethylene or a cyclic olefin, or ethylene alone. The amount of the α-olefin other than ethylene added can be selected according to the target molecular weight.

From the viewpoint of improving peel strength with copper foil or copper wiring, the olefin monomer is ethylene alone, or a mass ratio of an α-olefin component other than ethylene contained/an ethylene component may be preferably 1/7 or less and more preferably 1/10 or less. In this case, the content of the α-olefin monomer component other than ethylene contained in the copolymer is more preferably 6 mass% or less and further most preferably 4 mass% or less, or most preferably the olefin is ethylene alone.

When the total of the olefin monomer unit, aromatic vinyl compound monomer unit, and aromatic polyene monomer unit is taken as 100 mass%, the content of the olefin monomer unit in the present copolymer may be preferably 20 mass% or more, more preferably 25 mass% or more, and most preferably 30 mass% or more. The content of the olefin monomer unit being 20 mass% or more allows the toughness (elongation) and impact resistance of the cured product finally obtained to be improved, making it difficult to crack in the course of curing or crack during a heat cycle test of the cured product. In the present copolymer, the content of the olefin monomer unit is preferably 90 mass% or less.

The aromatic vinyl compound monomer may be an aromatic vinyl compound having 8 or more and 20 or less carbon atoms, and examples thereof include styrene, paramethylstyrene, paraisobutylstyrene, various vinylnaphthalenes, and various vinylanthracenes.

The content of the aromatic vinyl compound monomer unit contained in the present copolymer may be 0 mass% or more and 70 mass% or less, and it may be preferably 10 mass% or more and 60 mass% or less. With the content of the aromatic vinyl compound monomer unit of 70 mass% or less, the glass transition temperature of the finally obtained cured product of the resin composition becomes lower than a temperature in the vicinity of room temperature, making it possible to improve toughness and elongation at low temperatures, which is preferred. With the content of aromatic vinyl compound monomer unit of 10 mass% or more, effects whereby the aromatic property of the present copolymer is improved, the compatibility with a flame retardant and filler is improved, bleeding out of the flame retardant can be avoided, and the filling property of the filler can be improved, are demonstrated. The content of aromatic vinyl compound monomer unit being 10 mass% or more also enables obtaining a cured product with high peel strength from copper foil and copper wiring.

The aromatic polyene monomer may be a polyene having 5 or more and 20 or less carbon atoms and having a plurality of vinyl groups and/or vinylene groups in the molecule, being preferably various (ortho, meta, and para) divinylbenzenes or a mixture thereof, and a compound composed of carbon and hydrogen, substantially containing no oxygen, nitrogen, or halogen, having an aromatic vinyl structure such as divinylnaphthalene, divinylanthracene, p-2-propenylstyrene, and p-3-butenylstyrene. Alternatively, a bifunctional aromatic vinyl compound described in Japanese Patent Laid-Open No. 2004-087639, for example, 1,2-bis(vinylphenyl)ethane (abbreviation: BVPE) may be used. Among these, various (i.e., ortho-, meta- and para-) divinylbenzenes, or mixtures thereof are preferably used, and a mixture of meta and paradivinylbenzene is most preferably used. In the present specification, these divinylbenzenes may be collectively referred to as divinylbenzenes. Use of divinylbenzenes as the aromatic polyene is preferred, because the curing efficiency is high in a curing process to achieve easy curing.

Each of the monomers of the olefin, aromatic vinyl compound, and aromatic polyene may further include an olefin containing a polar group such as an oxygen atom, a nitrogen atom, etc., an aromatic vinyl compound containing an oxygen atom, a nitrogen atom, etc., or an aromatic polyene containing an oxygen atom, a nitrogen atom, etc. The total mass of the monomers containing these polar groups is preferably 10 mass% or less, more preferably 3 mass% or less, relative to the total mass of the composition, and it is most preferable that no monomers containing a polar group be contained. A proportion of the total mass of the monomer containing the polar group of 10 mass% or less enables improving dielectric properties (low dielectric constant, low dielectric loss) of a cured product made by curing the present composition.

Of the present copolymers, as an aspect of not containing the aromatic vinyl compound monomer unit (olefin-aromatic polyene copolymer), an ethylene-divinylbenzene copolymer, an ethylene-propylene-divinylbenzene copolymer, an ethylene-1-butene-divinylbenzene copolymer, an ethylene-1-hexene-divinylbenzene copolymer, an ethylene-1-octene-divinylbenzene copolymer, and the like, may be exemplified.

Of the present copolymers, as an aspect of containing the aromatic vinyl compound monomer unit (olefin-aromatic vinyl compound-aromatic polyene copolymer), an ethylene-styrene-divinylbenzene copolymer, an ethylene-propylene-styrene-divinylbenzene copolymer, an ethylene-1-hexene-styrene-divinylbenzene copolymer, an ethylene-1-octene-styrene-divinylbenzene copolymer, and the like, may be exemplified.

The number average molecular weight (Mn) of the copolymer may be 500 or more and 100,000 or less, preferably 500 or more and 50,000 or less, more preferably 500 or more and 20,000 or less, and still more preferably 500 or more and 10,000 or less. Mn being 100,000 or less makes it possible to obtain an appropriate viscosity for a varnish, and an effect of improving handleability upon use of the composition, is obtained.

The weight-average molecular weight (Mw) of the present copolymer may be preferably 10,000 or more and 200,000 or less, more preferably 20,000 or more and 200,000 or less, and still more preferably 20,000 or more and 150,000 or less. The value Mw/Mn obtained by dividing a weight-average molecular weight by a number average molecular weight may preferably be in a range of 2.0 ≤ Mw/Mn ≤ 13.0, more preferably 2.0 ≤ Mw/Mn ≤ 12.0, and still more preferably 2.0 ≤ Mw/Mn ≤10.0.

The number average molecular weight and weight-average molecular weight described in the present specification refer to the values measured as molecular weights in terms of standard polystyrene, determined by gel permeation chromatography (GPC). The measurement conditions for the GPC method described in the present specification are as follows:

### Measurement apparatus: Viscotek GPCMax

Column: TSK-GEL MultiporeHXL-M, φ7.8 × 300mm (3 columns)
Column temperature: 40°C
Detector: RI
Solvent: THF
Liquid flow rate: 1.0 ml/min
Sample concentration: 0.2 wt/vol%
Sample injection volume: 200 µL

In the present copolymer, the content of a vinyl group and/or a vinylene group (preferably the vinyl group) derived from the aromatic polyene unit may be 1.5 pieces or more and less than 20 pieces per number average molecular weight and is preferably 2 pieces or more and less than 7 pieces. The content of the vinyl group and/or vinylene group being 1.5 pieces or more enables providing a cured product with high cross-linking efficiency and a sufficient cross-linking density. The content of the vinyl groups derived from the aromatic polyene units (divinylbenzene units) per number average molecular weight in the copolymer may be obtained by comparing the number average molecular weight (Mn) in terms of standard polystyrene determined by a GPC (gel permeation chromatography) method known to the skilled person with the vinyl group content derived from the aromatic polyene units, determined by ¹H-NMR measurement. As an example, in the case where the content of the vinyl group derived from the aromatic polyene unit (divinylbenzene units) in the copolymer is 0.6 mass% resulting from comparison of the intensity of each peak area obtained by ¹H-NMR measurement, and the number average molecular weight in terms of standard polystyrene by GPC measurement is 49000, the molecular weight of the vinyl group derived from the aromatic polyene unit in the number average molecular weight is 299, which is the product of these. The product is divided by 130, which is the formula weight of the vinyl group, to obtain 2.3. That is, the content of the vinyl group derived from the aromatic polyene unit per number average molecular weight in the present copolymer is determined to be 2.3 pieces. The attribution of peaks obtained by ¹H-NMR measurement of the copolymer is known in literature. Further, a method for obtaining the composition of the copolymer from the comparison of the peak areas obtained by ¹H-NMR measurement is also known. Furthermore, adding data on peak areas and ratios thereof obtained by ¹³C-NMR spectra measured in a known quantitative mode to data obtained by the method using ¹H-NMR measurement, enables improving accuracy of the composition. Further, in the specification, the content of the divinylbenzene unit in the copolymer is determined from the peak intensity of the vinyl group derived from the divinylbenzene unit (according to ¹H-NMR measurement). That is, from the content of the vinyl group derived from the divinylbenzene unit, the content of the divinylbenzene unit is determined by assuming that one piece of vinyl group is derived from one piece of divinylbenzene unit in the copolymer.

The phenolic antioxidant, which is the component (B) contained in the present composition, is a component that demonstrate a synergistic effect of imparting excellent durability to the present composition when used in a specified amount in combination with components (C) and (D) described later. The present invention is characterized in that simply combining different types of antioxidants without taking their amounts into account does not allow a remarkable effect to be demonstrated in a composition mainly composed of the specific component (A).

In a preferred embodiment, when the value of the dielectric tangent of a cured product of the present composition in a measurement frequency range of 40 GHz as determined by a resonator method is defined as X1, and when the value of the dielectric tangent of a cured product of the present composition after being heated at 175°C for 24 hours, in a measurement frequency range of 40 GHz as determined by the resonator method is defined as X2, the value of (X1/X2) may be 2 or less, more preferably 1.5 or less, and still more preferably 1.2 or less. In other words, the present composition may exhibit an effect that, when the cured product of the present composition is heated (or naturally deteriorates due to being left to stand for a long period of time, equivalent to being heated), the dielectric tangent is less likely to be damaged.

More preferably, as a synergistic effect of the component (B), component (C), and component (D), the effect that the storage elastic modulus does not deteriorate compared to that before addition of antioxidant, may be obtained.

The amount of component (B) based on 100 grams (100 g) of the mass of the component (A), is in a range of 0.5 to 4 mmol in terms of the amount of substance (molar equivalent) per phenolic moiety of the component (B), more preferably in the range of 0.5 to 3 mmol, and still more preferably in the range of 0.5 to 2.5 mmol.

The component (B) refers to a compound that has a phenol skeleton (site) and has an action to stop a radical chain reaction. The component (B) may contain a monophenolic antioxidant, a polyphenolic antioxidant (such as a bisphenolic antioxidant or a triphenolic antioxidant), or a mixture thereof. The component (B) may preferably contain a hindered phenolic antioxidant (a compound having a bulky, sterically hindered substituent such as a tert-butyl group on an aromatic ring of the phenol site). From the viewpoint of improving durability against heat, the component (B) may have two or more aromatic rings in one molecule.

Examples of the monophenolic antioxidants may include those such as octadecyl 3-(3,5-di-tert-butyl-4-hydroxyphenyl)propionate, butylated hydroxyanisole, 2,6-di-tert-butyl-4-ethylphenol, stearin-β-(3,5-di-tert-butyl-4-hydroxyphenyl)propionate, 2-[1-(2-hydroxy-3,5-di-tert-pentylphenyl)ethyl]-4,6-di-tert-pentylphenyl=(meth)acrylate, 2-tert-butyl-6-(3-tert-butyl-2-hydroxy-5-methylbenzyl)-4-methylphenyl=(meth)acrylate, and 6-tert-butyl-4-[3-[(2,4,8,10-tetra-tert-butyldibenzo[d,f][1,3,2]dioxaphosphepin-6-yl)oxy]propyl]-2-methylphenol. These are available under the trade names of Sumilizer GS, Sumilizer GM, and Sumilizer GP (manufactured by Sumitomo Chemical Co., Ltd.), for example.

Examples of the polyphenolic antioxidants include those such as 2,2-methylene-bis(4-methyl-6-tert-butylphenol), N,N'-hexamethylenebis(3,5-ditert-butyl-4-hydroxybenzenepropionamide), 1,3,5-tris(3,5-di-tert-butyl-4-hydroxybenzyl)-1,3,5-triazine-2,4,6(1H,3H,5H)-trione, 4,4',4"-(1-methylpropanyl-3-ylidene)tris[6-tert-butyl-m-cresol], 6,6'-di-tert-butyl-4,4'-butylidenedi-m-cresol, 3,9-bis{2-[3-(3-tert-butyl-4-hydroxy-5-methylphenyl)propionyloxy]-1,1-dimethylethyl}-2,4,8,10-tetraoxaspiro[5.5]undecane, 1,3,5-tris(3,5-di-tert-butyl-4-hydroxyphenylmethyl)-2,4,6-trimethylbenzene, 2,2'-dimethyl-2,2'-(2,4,8,10-tetraoxaspiro[5.5]undecane-3,9-diyl)dipropane-1,1'-diyl=bis[3-(3-tert-butyl-4-hydroxy-5-methylphenyl)propanoate], 2,2'-methylenebis(6-tert-butyl-p-cresol), and 4,4'-thiobis(6-tert-butyl-m-cresol). These are available, for example, under the trade names of Sumilizer GA-80, Sumilizer MDP-S, Sumilizer WX-R (manufactured by Sumitomo Chemical Co., Ltd.), and the like. As the component (B), these may be used singly or in combinations of two or more thereof.

The thioether-based antioxidant, which is the component (C) contained in the present composition, refers to a compound that has a thioether skeleton (moiety) and has an action to stop a radical chain reaction. For the amount of component (C) based on 100 g of the mass of the component (A), the amount of substance (molar equivalent) per thioether moiety of the component (C), is in a range of 0.5 to 4 mmol, more preferably in a range of 0.5 to 3 mmol, and still more preferably in a range of 0.5 to 2.5 mmol.

Furthermore, based on 100 g of the mass of the component (A) in the present composition, the total amount of substance of component (B) and the amount of substance of component (C) may be in a range of 1 to 10 mmol or in the range of 2 to 10 mmol, more preferably in the range of 2 to 8 mmol, and still more preferably in the range of 2 to 7 mmol.

Examples of the component (C) may include those such as dialkylthiodipropionates (di(tridecyl) 3,3'-thiodipropionate, dilauryl thiodipropionate, dimyristyl thiodipropionate, distearyl thiodipropionate, and the like), pentaerythritol tetra(β-alkylthiopropionic acid) ester, and 2,2-bis{[3-(dodecylthio)-1-oxopropoxy]methyl}propane-1,3-diyl bis[3-(dodecylthio)propionate]. As the component (C), these may be used singly or in combinations of two or more thereof.

From the viewpoint of enhancing the synergistic effect with the component (B), the component (C) preferably has an acyclic structure.

In a preferred embodiment, the present composition may further contain (D) a phosphorus-based antioxidant. For the amount of component (D) based on 100 g of the mass of the component (A) in the composition, the amount of substance of the component (D) per phosphite moiety is preferably in a range of 0.5 to 4 mmol, more preferably in a range of 0.5 to 3 mmol, and still more preferably in a range of 0.5 to 2.5 mmol. Furthermore, based on 100 g of the mass of the component (A) in the composition, the total amount of substance of the components (B), (C), and (D) is preferably 2 to 10 mmol, more preferably 2 to 8 mmol, and still more preferably 2 to 7 mmol.

Compounding the three types of antioxidants in the predetermined amounts further exhibits a synergistic effect, resulting in extremely excellent dielectric properties. In particular, since even a slight difference in a dielectric tangent value (a difference on the order of 0.0001) has a large impact, even the slight decrease in the dielectric tangent can be said to have a significant effect.

Examples of the component (D) may include those such as 3,9-bis(octadecyloxy)-2,4,8,10-tetraoxa-3,9-diphosphaspiro[5.5]undecane, 3,9-bis(2,6-di-tert-butyl-4-methylphenoxy)-2,4,8,10-tetraoxa-3,9-diphosphaspiro[5.5]undecane, and 2,2'-methylenebis(4,6-di-tert-butylphenyl) 2-ethylhexyl phosphite, tris(nonylphenyl) phosphite, distearyl pentaerythritol diphosphite, tris(2,4-di-tert-butylphenyl) phosphite, bis(2,4-di-tert-butylphenyl)pentaerythritol diphosphite, tetrakis(2,4-di-tert-butylphenyl)-4,4'-biphenylene diphosphite, bis(2,6-di-tert-butyl-4-methylphenyl)pentaerythritol diphosphite, 2,2'-methylenebis(4,6-di-tert-butylphenyl)octyl phosphite, tetratridecyl-4,4'-butylidenebis(3-methyl-6-tert-butylphenyl)diphosphite, 2,2'-ethylidenebis(4,6-di-tert-butylphenyl)fluorophosphite, and bis(2,4,6-tri-tert-butylphenyl)pentaerythritol diphosphite.

From the viewpoint of enhancing the synergistic effect of the three types of antioxidants, the component (D) may preferably have an aromatic ring in the molecule.

The present composition may further contain any of optional additional components exemplified below, with the proviso that the effect of the present composition is not impaired.

### <Curing agent>

The curing agent that may be used in the present composition may be any known curing agent that may be used for polymerization or curing of conventional aromatic polyenes or aromatic vinyl compounds. Examples of such a curing agent include a radical polymerization initiator, a cationic polymerization initiator, and an anionic polymerization initiator, and a radical polymerization initiator may be preferably used. Preferably, the curing agent is an organic peroxide-based (peroxide) or azo-based polymerization initiator, which may be freely selected depending on the application and conditions. Catalogs showing organic peroxides may be downloaded from the following NOF CORPORATION websites.
https://www.nof.co.jp/business/chemicalchemical/product01
The organic peroxide is also described in the catalog and the like of FUJIFILM Wako Pure Chemical Corporation and Tokyo Chemical Industry Co., Ltd. The curing agent may be available from these companies. Also, a known photopolymerization initiator using light, ultraviolet rays, or a radiation may be used as the curing agent. Examples of the curing agents using the photopolymerization initiator include a photo radical polymerization initiator, a photo cationic polymerization initiator, or a photo anionic polymerization initiator. Such photopolymerization initiators are available, for example, from Tokyo Chemical Industry Co., Ltd. Furthermore, curing may be performed by radiation or electron beam itself. Alternatively, cross-linking and curing may be performed by thermal polymerization of the raw materials contained without a curing agent.

The amount of the curing agent used is not particularly limited, and in general preferably 0.01 to 10 parts by mass relative to 100 parts by mass of the composition. The composition preferably excludes a curing agent or a solvent. In the case where a curing agent such as peroxide-based (peroxide) or azo-based polymerization initiator is used, the curing treatment is performed at an appropriate temperature and time in consideration of the half-life thereof. The conditions in this case are optional according to the curing agent, and in general, a temperature range of about 50°C to 200°C is suitable.

### <Solvent (medium)>

An appropriate solvent may be added to the present composition on an as needed basis. The solvent is used to adjust the viscosity and fluidity of the composition. The solvent is preferably volatile, and, for example, cyclohexane, toluene, ethylbenzene, acetone or isopropanol is used. The amount used is preferably 10 parts by mass or less relative to 100 parts by mass of the copolymer from the viewpoint of moldability and handling of the composition before curing as a thermoplastic resin, and it is more preferable that substantially no solvent be used from the viewpoint of removal during curing and after curing. Substantially no solvent used means preferably 5 parts by mass or less, more preferably 1 part by mass or less, and most preferably 0 parts by mass. In the case of using as a varnish, it is preferable to add an appropriate solvent to the present composition. The solvent is used to adjust the viscosity and fluidity of the composition as a varnish. As the solvent, a solvent having a boiling point of a certain level or more is preferred, because an applied film having a uniform thickness is obtained with a solvent having a high boiling point under atmospheric pressure, that is, having a low volatility. The preferred boiling point is approximately 100°C or more, preferably 130°C or more and 300°C or less, under atmospheric pressure. Examples of the solvent suitably used for a varnish include toluene, xylene, mesitylene, ethylbenzene, limonene, ethylene glycol methyl ether acetate, ethylene glycol monoethyl ether acetate, and ethylene glycol monobutyl ether. The amount used is preferably in the range of 10 to 2000 parts by mass relative to 100 parts by mass of the present composition.

The present composition may be also in a varnish form in viscous liquid state depending on the composition and compounding ratio. For example, by using a sufficient amount of solvent and/or by using an appropriate amount of a liquid monomer, a varnish form may be obtained. For use as a varnish, it is preferable to add an appropriate solvent to the present composition. The solvent is used to adjust the viscosity and fluidity of the composition as a varnish. A solvent having a boiling point at a certain level or more is preferred, because the solvent having a high boiling point under atmospheric pressure, that is, low volatility, allows a uniform thickness of the applied film to be produced. The preferred boiling point is approximately 100°C or more, preferably 130°C or more and 300°C or less, under atmospheric pressure. Examples of the solvent suitably used for a varnish include xylene, mesitylene, ethylbenzene, limonene, ethylene glycol methyl ether acetate, ethylene glycol monoethyl ether acetate, and ethylene glycol monobutyl ether. The amount used is preferably in the range of 10 to 2000 parts by mass relative to 100 parts by mass of the present composition. A composition in varnish form may also be produced by utilizing polymerization liquid containing the present copolymer obtained by polymerization. For example, the polymerization liquid may undergo condensation treatment or treatment of removing residual monomers, and a solvent, other resin components, various additives, or the like may be added, if necessary, regulated for the component concentration or the solution viscosity, and the like, for production.

The varnish may be, for example, applied to a base material, or a base material may be impregnated with the varnish, and the solvent or the like may be removed by drying or the like, so that the varnish may be made into an uncured or semi-cured molded product. Generally, the molded product is in a form of a sheet, film, or tape.

### <Curing>

The present composition may be cured by a known method by reference to curing conditions (temperature, time and pressure) of the curing agent contained. In the case where the curing agent used is a peroxide, the curing conditions may be determined by reference to the half-life temperature and the like disclosed for each peroxide.

The present invention may also provide a laminate containing a layer containing the above composition and metal foil. That is, the present composition may be used as various insulating materials for wiring, preferably wiring of high frequency signals, such as coverlays, solder resists, build-up materials, interlayer insulators, bonding sheets, interlayer adhesives, and bumps for flip chip bonders. Further, the composition may be used as an electrically insulating layer or an adhesive layer of a base material/substrate such as a single-layer or multi-layer printed circuit board, a flexible printed circuit board, a CCL (copper clad laminate) or FCCL (flexible copper clad laminate) base material.

### <Viscosity>

The viscosity of the composition in the present specification shall be determined according to JIS Z 8803:2011 when the composition was prepared as a 50 mass% toluene solution. The viscosity of the present composition at 25°C is 100,000 cP or less at a shear rate of 1 s⁻¹, preferably 10,000 cP or less or 9,000 cP or less, more preferably 8,000 cP or less, and more preferably 5,000 cP or less. The lower limit of the viscosity is not particularly limited, but may be, for example, 500 cP or more and preferably 1,000 cP or more. Within such ranges of the viscosity, an effect of improving handleability as a varnish is obtained.

### <Production Method>

The composition containing the above-described copolymer may be obtained by allowing a raw material solution prepared by mixing the above-described olefin monomer, aromatic vinyl compound monomer, and aromatic polyene monomer in an appropriate solvent to undergo a single-site coordination polymerization reaction. In another embodiment, a step of polymerization in liquid monomers without using a solvent may be employed instead. In another embodiment, a vinyl aromatic copolymer may be obtained by a cationic polymerization reaction.

Examples of the solvents that may be used include a single or mixed solvent of saturated aliphatic solvents, aromatic hydrocarbons or halogenated hydrocarbons, such as pentane, hexane, heptane, cyclohexane, methylcyclohexane, benzene, toluene, ethylbenzene, xylene, mesitylene, limonene, chloro-substituted benzene, chloro-substituted toluene, methylene chloride, and chloroform. Preferably, a mixed alkane-based solvent, cyclohexane, toluene, ethylbenzene, and the like, may be used as the solvents.

The present copolymer may be produced without using a chain transfer agent, but the chain transfer agent may be used to lower the molecular weight. As such a chain transfer agent, a known chain transfer agent used with a so-called single-site coordination polymerization catalyst may be used, and examples thereof include, for example, hydrogen, alkylaluminums such as triisobutylaluminum, and 9-BBN as described in Chung T. C.: Macromolecules, 26, 3467 (1993).

A facility capable of producing the present composition may be, for example, a single or a plurality of connected tank polymerization cans, or a single or a plurality of connected linear or loop type pipe polymerization facilities. The pipe polymerization vessel may have various known mixers such as a dynamic or static mixer and a static mixer also used for heat removal, and various known coolers such as a cooler equipped with a thin tube for heat removal. A batch type preliminary polymerization vessel may also be included. Furthermore, a gas phase polymerization step may be adopted.

The polymerization temperature is preferably 0 to 200°C. The temperature of 0°C or higher is industrially advantageous because of a high polymerization rate, while the temperature of 200°C or lower has an effect whereby a transition metal compound is less likely to be decomposed. Industrially, the temperature is more preferably 30 to 160°C and particularly preferably 50 to 160°C. Pressure upon polymerization is generally preferably 1 to 100 atm, more preferably 1 to 30 atm, and industrially most preferably 1 to 10 atm.

Following completion of polymerization, an arbitrary step may be employed in recovering the copolymer from the reaction system, and preferably a steam stripping method or crumb forming method, which are known as methods for recovering raw rubber, may be employed. In a laboratory, a method for allowing a copolymer to be precipitated in a large amount of methanol, which is known as a methanol precipitation method, is generally convenient. Alternatively, without recovering the copolymer, a solvent and residual monomers may be totally or partially removed from polymerization liquid by evaporation using a rotary evaporator, film evaporator, or the like, and the resulting polymerization solution may be diluted with a solvent and used as a varnish.

### EXAMPLES

With referring to the manufacturing methods described in International Publication No. WO 00/37517, Japanese Patent Laid-Open No. 2009-161743, and Japanese Patent Laid-Open No. 2010-280771, a monomer amount, ratio, polymerization pressure, and polymerization temperature were appropriately changed to obtain respective copolymers shown in Table 1. The total of the olefin monomer units, aromatic vinyl compound monomer units, and aromatic polyene monomer units was set to 100 mass%. The number average molecular weights of the copolymers were also shown in Table 1. The molecular weight was measured as described above.

### <Content of vinyl group unit>

The content of vinyl group units derived from ethylene, styrene, and divinylbenzene in the copolymer was determined from peak area intensity assigned to each unit by ¹H-NMR. A sample was dissolved in deuterated 1,1,2,2-tetrachloroethane, and the measurement was performed at 23°C.

According to the compositions shown in Table 2, each Example and each Comparative Example were prepared using copolymers P-1 to P-3. The amount of the antioxidant was denoted as the amount of substance (mmol equivalent) per each functional group moiety when 100 parts by mass of the copolymer was taken as 100 g.

**[Table 1]**

| | Ethylene content | 1-Hexene content | Styrene content | Vinyl group of divinylbenzene | Number average molecular weight |
|---|---|---|---|---|---|
| Copolymerized oligomer or polymer | Mass% | Mass% | Mass% | (Piece/number average molecular weight) | Mn |
| P-1 | 49 | 0 | 50 | 2.3 | 49000 |
| P-2 | 43 | 3 | 53 | 4.5 | 40000 |
| P-3 | 51 | 0 | 40 | 3.8 | 5800 |

**[Table 2]**

| | | Example 1 | Example 2 | Example 3 | Example 4 | Example 5 | Example 6 | Example 7 | Example 8 | Example 9 |
|---|---|---|---|---|---|---|---|---|---|---|
| P-1 Parts by mass | | 100 | 0 | 0 | 100 | 0 | 0 | 0 | 0 | 0 |
| P-2 [Parts by mass] | | 0 | 100 | 0 | 0 | 100 | 0 | 0 | 0 | 0 |
| P-3 [Parts by mass] | | 0 | 0 | 100 | 0 | 0 | 100 | 100 | 100 | 100 |
| AO-80 [mmol equivalent] | | 0.81 | 0.81 | 0.81 | 0.81 | 0.81 | 0.81 | 1.35 | 2.70 | 2.70 |
| PEP-36 [mmol equivalent] | | 0.95 | 0.95 | 0.95 | 0.95 | 0.95 | 0.95 | 1.58 | 3.16 | 0.00 |
| AO-503 mmol equivalent | | 0.55 | 0.55 | 0.55 | 0.00 | 0.00 | 0.00 | 0.00 | 0.00 | 0.00 |
| AO-412S [mmol equivalent] | | 0.00 | 0.00 | 0.00 | 1.03 | 1.03 | 1.03 | 1.72 | 3.44 | 3.44 |
| Solvent (toluene) [parts by mass] | | 200 | 200 | 200 | 200 | 200 | 200 | 200 | 200 | 200 |
| Curing agent [parts by mass] | | 0.75 | 0.75 | 0.75 | 0.75 | 0.75 | 0.75 | 0.75 | 0.75 | 0.75 |
| Physical properties before heating | Dielectric tangent (40 GHz) | 0.00100 | 0.00110 | 0.0010 | 0.0010 | 0.0010 | 0.0010 | 0.0013 | 0.0014 | 0.0014 |
| | Deterioration of storage elastic modulus (at 25°C by DMA) | None | None | None | None | None | None | None | None | None |
| After heating at 175°C for 24 hours | Discoloration after heating | None | None | None | None | None | None | None | None | None |
| | Dielectric tangent (40 GHz) | 0.0008 | 0.0009 | 0.0009 | 0.0009 | 0.0013 | 0.0012 | 0.0012 | 0.0012 | 0.0011 |
| | Rate of change of dielectric tangent before and after heating | 0.8 | 0.8 | 0.8 | 0.9 | 1.2 | 1.2 | 0.9 | 0.8 | 0.8 |

**[Table 3]**

| | | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 | Comparative Example 10 |
|---|---|---|---|---|---|---|---|---|---|---|---|
| P-1 [Parts by mass] | | 100 | 0 | 0 | 0 | 0 | 0 | 0 | 0 | 0 | 0 |
| P-2 [Parts by mass] | | 0 | 0 | 0 | 0 | 0 | 0 | 0 | 0 | 0 | 0 |
| P-3 [Parts by mass] | | 0 | 100 | 100 | 100 | 100 | 100 | 100 | 100 | 100 | 100 |
| AO-80 [mmol equivalent] | | 0.00 | 0.00 | 0.81 | 2.43 | 4.86 | 0.00 | 0.00 | 0.81 | 0.27 | 5.40 |
| PEP-36 [mmol equivalent] | | 0.00 | 0.00 | 0.00 | 0.00 | 0.00 | 2.84 | 0.00 | 0.00 | 0.32 | 0.00 |
| AO-503 [mmol equivalent] | | 0.00 | 0.00 | 0.00 | 0.00 | 0.00 | 0.00 | 0.00 | 0.00 | 0.00 | 0.00 |
| AO-412S [mmol equivalent] | | 0.00 | 0.00 | 0.00 | 0.00 | 0.00 | 0.00 | 3.10 | 1.03 | 0.34 | 6.88 |
| Solvent (toluene) [parts by mass] | | 200 | 200 | 200 | 200 | 200 | 200 | 200 | 200 | 200 | 200 |
| Curing agent [parts by mass] | | 0.75 | 0.75 | 0.75 | 0.75 | 0.75 | 0.75 | 0.75 | 0.75 | 0.75 | 0.75 |
| Physical properties before heating | Dielectric tangent (40 GHz) | 0.0006 | 0.0012 | 0.0010 | 0.0011 | 0.0013 | 0.0012 | 0.0012 | 0.0009 | 0.0010 | 0.0021 |
| | Deterioration of storage elastic modulus (at 25°C by DMA) | None | None | None | None | None | None | None | None | None | None |
| After heating at 175°C for 24 hours | Discoloration after heating | Discolored | Discolored | Discolored | Discolored | Discolored | Discolored | Discolored | Discolored | Discolored | None |
| | Dielectric tangent (40 GHz) | Unmeasurab le | 0.0109 | 0.0044 | 0.0095 | 0.0011 | 0.0085 | 0.0086 | 0.0089 | 0.0092 | 0.0015 |
| | Rate of change of dielectric tangent before and after heating | Unmeasurab le | 9.2 | 4.5 | 9.0 | 0.9 | 7.2 | 7.2 | 9.5 | 8.8 | 0.8 |

The main raw materials are as follows. As divinylbenzene, divinylbenzene (meta and para mixture, divinylbenzene purity: 81%) manufactured by NIPPON STEEL Chemical & Material Co., Ltd., was used. A curing agent "PERHEXYNE 25B" (2,5-dimethyl-2,5-bis(tert-butylperoxy)hexyne-3, manufactured by NOF CORPORATION) was used. Toluene (commercial product) was used as the solvent.

The component (B) used is as follows.
3,9-Bis{2-[3-(3-tert-butyl-4-hydroxy-5-methylphenyl)propionyloxy]-1,1-dimethylethyl}-2,4,8,10-tetraoxaspiro[5.5]undecane ("ADK STAB AO-80", molecular weight: 741, manufactured by ADEKA Corporation)

The component (C) used is as follows.
2,2-Bis{[3-(dodecylthio)-1-oxopropoxy]methyl}propane-1,3-diyl bis[3-(dodecylthio)propionate] ("ADK STAB AO-412S", molecular weight: 1162, manufactured by ADEKA Corporation)
Di(tridecyl) 3,3'-thiodipropionate ("ADK STAB AO-503", molecular weight:543, manufactured by ADEKA Corporation)

The component (D) used is as follows.
3,9-Bis(2,6-di-tert-butyl-4-methylphenoxy)-2,4,8,10-tetraoxa-3,9-diphosphaspiro[5.5]undecane ("ADK STAB PEP-36", molecular weight: 633, manufactured by ADEKA Corporation)

### <Fabrication of varnish, fabrication of cured sheet>

Using a vessel equipped with a heating and cooling jacket and stirring blades, the P-1 (ethylene-styrene-divinylbenzene copolymer) obtained in Synthesis Example and a solvent (toluene) were heated to approximately 60°C and stirred to dissolve the copolymer. Furthermore, an antioxidant and a curing agent were added to 100 parts by mass of the resin component in the amounts of the predetermined parts by mass shown in Tables 2 and 3, and the mixture was dissolved and mixed under stirring to obtain a composition in varnish form. It is to be noted that the amount of substance of the antioxidant shown in the tables is the value when the mass of the copolymer is 100 g. The obtained composition was poured into a silicon mold (frame length of 7 cm, width of 7 cm, thickness of 0.5 mm, 1.0 mm, or 2.0 mm) on a Teflon (registered trademark) sheet placed on a glass plate, air-dried, and then further dried in a vacuum dryer at 60°C for 3 hours or longer to obtain an uncured sheet. Furthermore, a Teflon sheet and a SUS mold were placed under a load of 5 MPa in a press machine, and heat treatment was performed at 120°C for 30 minutes, 150°C for 30 minutes and thereafter 200°C for 120 minutes. The Teflon sheet and the SUS mold were then removed to obtain a cured sheet.

### <Measurement of dielectric loss (dielectric tangent)>

The dielectric tangent was measured at 23°C and 40 GHz using a cavity resonator perturbation method (an 8722ES network analyzer manufactured by Agilent Technologies Inc., a split cylinder resonator (40 GHz) manufactured by Keysight Technologies, Inc.) and using a sample of 0.2 mm × 25 mm × 30 mm cut out from the sheet. In order to confirm the high-temperature thermal oxidation deterioration resistance of the material, the sheet was left to stand at 175°C in an air atmosphere for 24 hours, and then the dielectric tangent was measured. When the rate of change X1/X2, which is a ratio of a dielectric tangent value before heating (X1) to a dielectric tangent value after heating (X2) ("Rate of change of dielectric tangent before and after heating" in the table) was 1.2 or less, which was considered no deterioration of the sheet, and the value of greater than 1.2 and less than 2.0 was considered within the acceptable range of deterioration, and the value greater than 2.0 was considered deterioration thereof.

### <Measurement of storage elastic modulus>

Using a dynamic viscoelasticity measuring apparatus (RSA-G2 manufactured by Rheometric Scientific) measurements were performed at a frequency of 1 Hz in a temperature range of 20°C to +300°C. A measurement sample (3 mm × 40 mm) was cut out from a film with a thickness of approximately 0.2 mm and measured to determine the storage elastic modulus. The main measurement parameters in the measurement are as follows.
Measurement frequency: 1 Hz
Rate of temperature rise: 3°C/min
Measurement length of sample: 13 mm
Test Type = Dynamic Temperature Ramp (DTempRamp)
Initial Static Force: 5.0 g
Auto Tension Sensitivity: 1.0 g
Max Auto Tension Rate: 0.033 mm/s
Max Applied Strain: 1.5%
Min Allowed Force: 1.0 g
Distortion: 0.1%

In the value of a storage elastic modulus at 25°C, whether the storage elastic modulus at 25°C deteriorated due to the addition of antioxidants was evaluated according to the following criteria ("Deterioration of storage elastic modulus at 25°C by DMA" in the table). When the value of the storage elastic modulus of the sample without the antioxidant (before heating) was set to 1, the value of 0.8 or more of the storage elastic modulus of the sample with the antioxidant already added, was considered "no deterioration" ("none" in the tables), and the value of less than 0.8 of the storage elastic modulus was considered "deterioration."

### <Appearance evaluation>

In order to confirm the high-temperature thermal oxidation deterioration resistance of the material, the sheet was left to stand at 175°C in an air atmosphere for 24 hours, and then a color change of the sheet was visually evaluated ("Discoloration after heating" in the table).

The above evaluation results are also shown in Tables 2 and 3. All of Examples resulted in no deterioration of the storage elastic modulus, no discoloration after heating, and no deterioration of the dielectric tangent after heating.

In contrast, Comparative Example 1, in which none of the antioxidants was added, resulted in not only the discoloration but also the severe damage by heating, making it unsuitable for practical use.

Comparative Example 2, in which none of the antioxidants was added, resulted in the discoloration by heating and the significant deterioration of the dielectric tangent.

In Comparative Examples 3 to 5, which used the component (B) singly as the antioxidant, all of them were discolored by heating.

In Comparative Example 6, which used the component (D) singly as the antioxidant, the dielectric tangent significantly deteriorated by heating.

In Comparative Example 7, which used the component (C) singly as the antioxidant, the dielectric tangent significantly deteriorated by heating.

In Comparative Example 8, which used the components (B) and (C) as the antioxidants, the total amount of substance of which was small, the dielectric tangent significantly deteriorated by heating.

In Comparative Example 9, which used the components (B), (C), and (D) as the antioxidants, the total amount of substance of which was small, the dielectric tangent significantly deteriorated by heating.

In Comparative Example 10, which used the components (B) and (C) as the antioxidants, the total amount of substance of which was too large, the dielectric tangent was too high both before and after heating.

## Claims

1. A composition, comprising:
(A) a curable hydrocarbon-based resin;
(B) a phenolic antioxidant;
(C) a thioether-based antioxidant; and
(D) a phosphorus-based antioxidant, and
wherein a total amount of substance of the components (B), (C), and (D) is within a range of 2 to 10 mmol, based on 100 g of a mass of the component (A) in the composition.

2. The composition according to claim 1, wherein an amount of substance per phenol moiety of the component (B) is in a range of 0.5 to 4 mmol, an amount of substance per thioether moiety of the component (C) is in a range of 0.5 to 4 mmol, and an amount of substance per phosphite moiety of the component (D) is in a range of 0.5 to 4 mmol, based on 100 g of a mass of the component (A) in the composition.

3. The composition according to claim 1 or 2, wherein the component (A) comprises an olefin-aromatic vinyl compound-aromatic polyene copolymer.

4. The composition according to claim 3, wherein the component (A) satisfies all of the following conditions (1) to (4):
(1) a number average molecular weight of the copolymer is 500 or more and 100,000 or less;
(2) an aromatic vinyl compound monomer is an aromatic vinyl compound having 8 or more and 20 or less carbon atoms, and a content of the aromatic vinyl compound monomer unit is 0 mass% or more and 70 mass% or less;
(3) an aromatic polyene monomer unit is one or more selected from polyenes having 5 or more and 20 or less carbon atoms and having a plurality of vinyl groups and/or vinylene groups in the molecule, and a content of the vinyl group and/or vinylene group derived from the aromatic polyene monomer unit is 1.5 pieces or more and less than 20 pieces per number average molecular weight; and
(4) an olefin monomer unit is one or more selected from olefins having 2 or more and 20 or less carbon atoms, and a total of units of the olefin monomer, the aromatic vinyl compound monomer, and the aromatic polyene monomer is 100 mass%.

5. The composition according to any one of claims 1 to 4, wherein, given that the value of a dielectric tangent of a cured product of the composition in a measurement frequency range of 40 GHz as determined by a resonator method is defined as X1, and
given that the value of a dielectric tangent of a cured product of the composition after being heated at 175°C for 24 hours, in a measurement frequency range of 40 GHz as determined by the resonator method is defined as X2,
the value of (X1/X2) is 2 or less.

6. The composition according to any one of claims 1 to 5, wherein the component (B) has two or more aromatic rings in one molecule.

7. The composition according to any one of claims 1 to 6, wherein the component (C) has an acyclic structure.

8. The composition according to any one of claims 1 to 7, wherein the component (D) has an aromatic ring in its molecule.

9. A cured product of the composition according to any one of claims 1 to 8.

10. A laminate, comprising:
a layer comprising the composition according to any one of claims 1 to 8, and
a metal foil.

11. A cured product of the laminate according to claim 10.

12. A single-layer CCL, multilayer CCL, single-layer FCCL, or multilayer FCCL substrate comprising the cured product according to claim 11.
